# FASCICULE DE BREVET EUROPEEN

(11) **EP 0 778 723 B1**
(45) Date de publication et mention de la délivrance du brevet: **03.11.1999**
(21) Numéro de dépôt: 96402623.1
(22) Date de dépôt: 04.12.1996
(51) Int. Cl.: H05K 3/36

(54) **Assemblage de cartes électroniques, et procédé de fabrication d'un tel assemblage**
Baugruppe aus elektrischen Leiterplatten, sowie Verfahren zu ihrer Herstellung
Assembly of electronic boards, and process for manufacturing such an assembly

(30) Priorité: 07.12.1995 FR 9514497
(43) Date de publication de la demande: 11.06.1997
(73) Titulaire: SAGEM S.A., 75016 Paris (FR)
(72) Inventeur: Cadet, Yves, 95520 Osny (FR); Tutka, André, 95100 Argenteuil (FR)
(74) Mandataire: Fort, Jacques

(56) Documents cités:
- EP-A- 0 642 166
- DE-A- 4 324 479
- DE-A- 4 326 104
- US-A- 5 456 004
- PATENT ABSTRACTS OF JAPAN vol. 95, no. 6, 31 Juillet 1995 & JP 07 066330 A (PFU), 10 Mars 1995,
- MOTOROLA TECHNICAL DEVELOPMENTS, vol. 14, Décembre 1991, SCHAUMBURG, ILLINOIS US, pages 27-28, XP000276140 K. P. GORE ET AL.: "Mechanical alignment of C5 ICs with three corner peg concept using larger solder spheres"

## Description

La présente invention a pour objet un assemblage unitaire de cartes électroniques équipées de micro-composants, comprenant une carte imprimée de base portant des micro-composants, sur laquelle est reporté au moins une carte supplémentaire, de taille inférieure à celle de la carte de base, portant également des micro-composants.

Le fonctionnement de nombreux appareils à grande diffusion est commandé par une carte imprimée portant des micro-composants électroniques. L'augmentation continue du nombre des fonctions à remplir par de tels appareils se traduit par une augmentation du nombre de micro-composants nécessaires et donc de la surface reprise pour les porter. Ces micro-composants ont des natures diverses. Certains de ces composants comportent des plages de sortie réparties à un pas beaucoup plus faible que les plages de composants d'autre nature. Lorsque tous les composants sont fixés sur une même carte, la précision de fabrication requise pour cette dernière est conditionnée par le pas de répartition des plages de composants les plus exigeants. Or tout accroissement de précision augmente le coût de réalisation de la carte et cela d'autant plus que la carte est de grande dimension. Le prix des cartes destinées à des appareils de grande diffusion doit être très bas, ce qui implique d'une part un coût de fabrication faible, d'autre part un taux de rebut faible.

Le document DE-A-4 326 104 décrit un assemblage unitaire de cartes électroniques équipées de micro-composants.

La présente invention vise à fournir un assemblage unitaire de cartes électroniques destiné à être substitué à une carte unique, répondant mieux que les cartes antérieures aux exigences de la pratique, notamment en ce qu'il permet d'arriver à un coût plus faible pour des fonctions remplies identiques.

Dans ce but, l'invention propose notamment un assemblage unitaire de cartes électroniques comprenant :
une carte imprimée de base portant des micro-composants ayant des sorties réparties à un premier pas,
au moins une carte coeur, de taille inférieure à celle de la carte de base, portant des micro-composants dont certains au moins ont des sorties réparties à un second pas, inférieur au premier, la carte de base étant réalisée par une technologie ne permettant d'atteindre qu'une densité de contact moins haute que celle de la carte coeur,
ladite carte coeur étant reliée mécaniquement et électriquement à la carte support par des billes conductrices soudées réparties suivant un réseau à deux dimensions, les billes conductrices étant interposées directement entre la carte coeur et la carte de base.

La carte coeur sera fréquemment à haute densité d'interconnexion (par exemple de la classe 5) et destinée à recevoir des composants ayant des sorties à faible pas (typiquement 0,5 mm). Eventuellement elle porte aussi des composants passifs. Elle sera souvent de petite taille et ses déformations en cours de fabrication sont donc moins à craindre. La carte de base, à plus faible densité d'interconnexion, peut être de grande taille, par exemple de 230 x 130 mm. Ces connections par billes permettent d'éviter des liaisons entre les cartes par une nappe de conducteurs dont les fils doivent être séparés d'au moins 1/20ème de pouce (1,27 mm) dans la technologie disponible à l'heure actuelle).

Pour assurer un centrage précis de la carte coeur sur la carte de base sans nécessité d'éléments exigeant des opérations supplémentaires, des pions de soudure solidaires de la carte coeur peuvent être prévus en face de trous ménagés dans la carte de base, de façon à s'engager dans ces trous lors d'une opération de refusion globale qui intervient lors de la fabrication.

L'assemblage peut comporter plusieurs cartes coeur au lieu d'une seule ; il peut comporter, de plus, un ou plusieurs macro-composants fixés sur la carte coeur et/ou la carte de base.

Le diamètre des billes de liaison mécanique et électrique entre la carte coeur et la carte support peut être supérieur à l'épaisseur de composants montés en surface sur la carte de base. Si les billes sont dans la partie centrale de la carte coeur, des micro-composants montés en surface peuvent être placés sur la carte de base, au-dessous des parties latérales de la carte coeur, ce qui permet d'augmenter encore le nombre de composants montés sur l'assemblage.

L'invention propose également un procédé de fabrication d'un assemblage du genre ci-dessus défini, ce procédé étant défini par la revendication 9, permettant un montage sur une ligne de fabrication continue, ne comportant aucune dérivation, comme on le verra plus loin, ce qui réduit le coût.

Un tel procédé de fabrication d'assemblage unitaire de cartes électroniques notamment comporte les étapes suivantes :
(a) on sérigraphie de la crème à braser sur les plages de contact d'une carte à circuit imprimé de base, avec un premier pas de répartition des contacts destinés à recevoir des micro-composants,
(b) on sérigraphie de la crème à braser sur les plages de contact sur une face d'une carte coeur, de dimension inférieure à celle de la carte de base, avec le même pas de répartition des contacts, pour constituer des billes de brasure,
(c) on fixe les micro-composants sur les deux cartes sur machines automatiques et, après report et centrage de la carte coeur sur la carte de base,
(d) on porte l'ensemble ainsi constitué à une température de refusion de la soudure ou brasure des billes et des composants.

Au cours de l'étape (b), on obtient des billes de brasure plomb-étain qui permettront la réalisation d'interconnexions entre cartes coeur-base à l'issue d'une refusion qui peut être obtenue dans un four à passage réalisant un cycle de température calibré.

Les caractéristiques ci-dessus ainsi que d'autres apparaîtront mieux à la lecture de la description qui suit d'un mode particulier de réalisation, donné à titre d'exemple non limitatif. La description se réfère aux dessins qui l'accompagnent, dans lesquels :
- la figure 1 est une vue en coupe schématique, où l'échelle n'est pas respectée, montrant un assemblage ayant une seule carte coeur sur une carte de base ;
- la figure 2 est une vue de détail à grande échelle, destinée à montrer un pion de centrage, avant et après refusion.

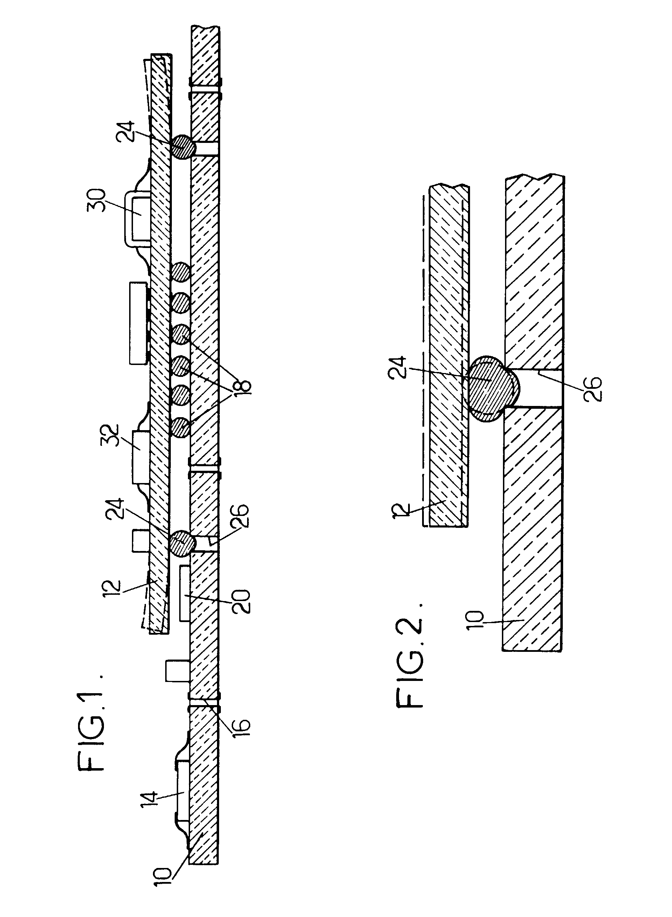

L'assemblage unitaire montré schématiquement en figure 1 comprend une carte de base 10 et une carte coeur 12, de plus petite dimension, reportée sur la carte de base.

La carte de base, qui peut être de grande dimension, est réalisée par une technologie ne permettant pas la même densité de compact que la carte coeur. La carte de base 10 est par exemple constituée en résine époxy renforcée par de la fibre de verre, en classe 3, permettant de réaliser par des technologies classiques à vernis épargne et sérigraphie, des pistes de 310 microns d'épaisseur, séparées de 310 microns, permettant de recevoir notamment des micro-composants montés en surface 14 et des macro-composants, avec éventuellement des trous métallisés 16 de via. Cette carte de base aura en général une épaisseur classique de 1,6 mm.

La carte coeur peut être constituée en technologie de classe 5, et aura en général une épaisseur inférieure à celle de la carte de base. Elle peut notamment être constituée par un tissu de verre à fibres croisées avec enrobage epoxy, d'épaisseur au moins égale à 0,8 mm. En classe 5 il est possible de réaliser des pistes et des plages de réception des sorties de micro-composants réparties au pas de 0,5 mm.

Les liaisons électriques entre la carte de base 10 et la carte coeur 16 sont réalisées par des billes de soudure ou brasure 18 placées directement entre les cartes. Ces billes sont avantageusement prévues dans une partie centrale de la carte coeur. Ils sont réparties suivant un réseau à deux dimensions, de façon à réduire les contraintes mécaniques. Elles peuvent être en nombre élevé, par exemple réparties en six rangées de 20 billes, avec un écartement entre rangées et entre billes de 2 mm. Un diamètre initial des billes de 1 mm, conduisant à une distance entre cartes comprise entre 0,5 et 0,8 mm après solidarisation par refusion, a donné de bons résultats. Les billes peuvent notamment être en alliage étain-plomb à 2 % d'argent.

Un tel intervalle dépassant 0,6 mm permet, si nécessaire, de fixer à plat des composants minces 20 sous les bords de la carte coeur. Les déformations de cette dernière ne pouvant conduire qu'à un relèvement des bords, la fixation de micro-composants de 0,2 mm d'épaisseur, maintenant disponibles, ne pose pas de problème.

Pour limiter les contraintes mécaniques appliquées aux billes de liaison électrique 18, la carte coeur 12 est fixée à la carte de base 10 par des billes de soudure ou brasure supplémentaires 24, entourant les billes 18. Ces billes peuvent être en petit nombre, 3 ou 4 par exemple. Dans le cas illustré en figures 1 et 2, elles assurent non seulement la fixation de la carte coeur 12, mais aussi son centrage exact sur la carte de base 10. Pour cela, des trous 26 de diamètre inférieur au diamètre initial des billes 24 sont percés dans la carte de base 10. Ils assurent un centrage lorsque la carte coeur 12 portant les billes est déposée, comme indiqué en tirets sur la figure 2. Sur l'assemblage terminé, elles assurent une liaison énergique. La refusion des billes 24 provoque en effet leur pénétration partielle dans les trous 26, comme indiqué en traits pleins sur la figure 2.

Lorsqu'on utilise des billes 18 ayant un diamètre initial de 0,7 mm, on pourra utiliser des billes de fixation mécanique 24 ayant un diamètre initial de 1,35 mm, destiné à s'engager dans un trou de 0,75 mm de diamètre. De façon plus générale, les billes de fixation mécanique 24 auront un diamètre initial nettement supérieur à celui des billes de liaison électrique 18.

On voit sur la figure 2 que les billes de liaison mécaniques 24 constituent, après refusion, des pions soudés s'engageant dans les trous 26, garantissant une liaison énergique et limitant au surplus la déformation de la carte coeur.

On décrira maintenant un procédé possible de fabrication en série d'assemblages unitaires.

Les cartes coeur 12, ayant par exemple une dimension de 68x87 mm, peuvent être réalisées par lots occupant chacun un panneau de stratifié verre-epoxy de 300x400 mm. Les motifs de la face qui doit recevoir des composants sont gravés successivement à l'aide d'un photo-répéteur. Une couche mince étain-plomb est appliquée sur les plages destinées à recevoir les contacts des composants. Sur l'autre face, de la pâte à braser est déposée par sérigraphie aux emplacements des billes de liaison électrique 18 et les billes de liaison mécanique 24, en quantité telle qu'on obtienne ultérieurement les billes de diamètre souhaité. Le panneau est soumis à un cycle de refusion qui provoque la formation des billes du fait de la tension superficielle. Le panneau peut alors être découpé en cartes coeur 12 prêtes à être reportées sur des cartes de base respectives. Ce report peut s'effectuer à l'aide d'une machine du même genre que celui utilisé pour reporter des composants électroniques, du fait des dimensions réduites de la carte coeur.

Les cartes de base sont réalisées de façon traditionnelle, sur une machine n'assurant pas le même degré de précision que celui requis pour les cartes coeur.

Le report de chaque carte coeur sur la carte de base respective peut être réalisé sur une machine approvisionnée par un convoyeur amenant simultanément la carte de base et la carte coeur. Chaque couple carte de base-carte coeur peut être placé sur un plateau ayant des alvéoles de réception des billes de liaison mécanique 24, garantissant un positionnement précis et une prise correcte de la carte coeur par l'organe de préhension de la machine. Les micro-composants sont fixés sur les deux cartes, généralement par collage, les opérations pouvant s'effectuer en séquence sur deux machines différentes ayant des précisions adaptées. Puis la carte coeur équipée de ses composants est posée et centrée sur la carte de base. Enfin l'ensemble est porté à une température de refusion sous atmosphère inerte, destiné à réaliser les liaisons électriques et mécaniques. Cette technologie peut être mise en oeuvre sans nettoyage des cartes.

Dans une variante de réalisation, les cartes coeur ne sont préparées que sur leur face inférieure avant d'être découpées et la gravure et la sérigraphie des deux cartes destinées à constituer un même ensemble alors qu'elles sont portées par le même plateau, mais sur deux machines successives ayant des précisions différentes.

Comme indiqué plus haut, d'autres variantes encore de réalisation sont possibles. La carte de coeur peut recevoir non seulement des composants 32 montés en surface, mais aussi des macro-composants 30 enrobés dans de la matière plastique et des composants dits QFP. Le procédé peut être adapté à une technologie double face.

## Revendications

1. Assemblage unitaire de cartes électroniques équipées de micro-composants comprenant :
une carte imprimée de base (10) portant des micro-composants ayant des sorties réparties à un premier pas, et
au moins une carte coeur (12) de taille inférieure à celle de la carte de base, portant des micro-composants,
ladite carte coeur (12) étant reliée mécaniquement et électriquement à la carte support par l'intermédiaire de billes conductrices soudées (18) réparties suivant un réseau à deux dimensions,
certains au moins des microcomposants portés par la carte coeur ayant des sorties réparties à un second pas, inférieur au premier,
caractérisé en ce que la carte de base est réalisée par une technologie ne permettant d'atteindre qu'une densité de contact moins haute que celle de la carte coeur et en ce que les billes conductrices sont interposées directement entre la carte coeur et la carte de base.

2. Assemblage selon la revendication 1, caractérisé en ce que les billes conductrices (18) sont disposées uniquement dans une partie centrale de la carte coeur.

3. Assemblage selon la revendication 1 ou 2, caractérisé en ce qu'il comporte, de plus, au moins un composant fixé à la carte coeur et ayant une taille supérieure à celle des micro-composants fixés sur la carte de base.

4. Assemblage selon la revendication 2, caractérisé en ce qu'il comporte des micro-composants (20) placés sous la carte coeur (12) et fixés à la carte de base (10), autour des billes conductrices.

5. Assemblage unitaire selon l'une quelconque des revendications précédentes, caractérisé par des pions (24) de soudure s'engageant dans des trous (26) ménagés dans la carte de base et disposés autour des billes conductrices.

6. Assemblage selon la revendication 5, caractérisé en ce que les pions de soudure sont au nombre de trois ou quatre et répartis à la périphérie de la carte coeur.

7. Assemblage selon la revendication 5 ou 6, caractérisé en ce que les pions sont constitués à partir de billes ayant un diamètre supérieur à celui des billes conductrices soudées (18).

8. Assemblage selon l'une quelconque des revendications 1 à 7, caractérisé en ce que la carte de base (10)est en résine renforcée par de la fibre de verre et la carte coeur est en tissu de verre à fibres croisées avec enrobage.

9. Procédé de fabrication d'assemblage unitaire de cartes électroniques selon la revendication 1 comportant les étapes suivantes :
(a) au cours d'une même phase de fabrication, on sérigraphie de la crème à braser sur des plages de contact d'une carte à circuit imprimé de base (10) ayant un premier pas de répartition des contacts destinés à recevoir des micro-composants, et on sérigraphie de la crème à braser sur des plages de contact d'une face d'une carte coeur (12), avec le même pas de répartition des plages de contact, que pour la carte de base pour constituer des billes de brasure, la carte coeur ayant des dimensions inférieures à celles de la carte de base, ayant un pas de répartition des contacts de réception de micro-composants plus court que celui de la carte de base et la carte coeur et la carte de base étant amenées sur un même plateau support de transport ;
(b) on fixe les micro-composants sur les deux cartes sur une machine automatique et, après report et centrage de la carte coeur sur la carte de base ;
(c) on porte l'ensemble ainsi constitué à une température de refusion de la soudure ou brasure des billes et des composants.

10. Procédé selon la revendication 9, caractérisé en ce qu'on dépose également, à la périphérie de la face inférieure de la carte coeur, des billes supplémentaires, de plus grand diamètre que les premières, destinées à s'engager dans des trous (26) de la carte de base, pour centrer mécaniquement la carte coeur au cours du procédé et fixer la carte coeur sur l'assemblage terminé.

## Patentansprüche

1. Anordnung von mit Mikrokomponenten versehenen elektronischen Karten, umfassend:
eine Mikrokomponenten tragende bedruckte Basiskarte (10), die Ausgänge aufweist, die mit einer ersten Schrittweite verteilt sind, und
wenigstens eine Mikrokomponenten tragende Hauptkarte (12) mit einer geringeren Größe als die der Basiskarte,
wobei die Hauptkarte (12) mechanisch und elektrisch mit der Trägerkarte mittels leitender Lötkugeln (12) verbunden ist, die gemäß einem zweidimensionalen Muster verteilt sind,
wobei zumindest bestimmte Mikrokomponenten, die von der Hauptkarte getragen werden, Ausgänge aufweisen, die mit einer zweiten Schrittweite verteilt sind, der kleiner als der erste ist,
**dadurch gekennzeichnet, daß** die Basiskarte mittels einer Technologie verwirklicht ist, die es nur erlaubt, eine weniger große Kontaktdichte zu erreichen als die der Hauptkarte und dadurch, daß die leitenden Kugeln direkt zwischen der Hauptkarte und der Basiskarte angeordnet sind.

2. Anordnung nach Anspruch 1, **dadurch gekennzeichnet, daß** die leitenden Kugeln (18) nur in einem zentralen Teil der Hauptkarte angeordnet sind.

3. Anordnung nach Anspruch 1 oder 2, **dadurch gekennzeichnet, daß** sie darüberhinaus wenigstens eine Komponente umfaßt, die auf der Hauptkarte befestigt ist und eine größere Größe aufweist als die der Mikrokomponenten, die auf der Basiskarte befestigt sind.

4. Anordnung nach Anspruch 2, **dadurch gekennzeichnet, daß** sie Mikrokomponenten (20) umfaßt, die unter der Hauptkarte (12) angeordnet sind und auf der Basiskarte (10) befestigt sind, und zwar um die leitenden Kugeln herum.

5. Anordnung nach einem der vorhergehenden Ansprüche, **gekennzeichnet durch** Lötklumpen (24), die in Löcher (26) eingreifen, die in der Basiskarte ausgespart sind und um die leitenden Kugeln herum angeordnet sind.

6. Anordnung nach Anspruch 5, **dadurch gekennzeichnet, daß** die Lötklumpen in einer Anzahl von 3 oder 4 vorliegen und an dem Rand der Hauptkarte verteilt sind.

7. Anordnung nach Anspruch 5 oder 6, **dadurch gekennzeichnet, daß** die Klumpen aus Kugeln gebildet sind, die einen größeren Durchmesser aufweisen, als derjenige der leitenden Lötkugeln (18).

8. Anordnung nach einem der Ansprüche 1 bis 7, **dadurch gekennzeichnet, daß** die Basiskarte aus Harz gebildet ist, das mit Glasfaser verstärkt ist, und die Hauptkarte aus Gewebe aus gekreuzten Glasfasern mit Ummantelung gebildet ist.

9. Verfahren zur Herstellung einer Anordnung von elektronischen Karten nach Anspruch 1, umfassend die folgenden Schritte:
a) während einem gleichen Fabrikationsschritt wird die Lötpaste auf Kontaktbereiche einer Basiskarte (10) mit bedrucktem Schaltkreis serigrafiert, die eine erste Verteilungsschrittweite von Kontakten aufweist, die dazu bestimmt sind, die Mikrokomponenten aufzunehmen, und die Lötpaste wird auf die Kontaktbereiche einer Seite einer Hauptkarte (12) serigrafiert, und zwar mit der gleichen Verteilungsschrittweite der Kontaktbereiche wie für die Basiskarte, um Lötkugeln zu bilden, wobei die Hauptkarte geringere Dimensionen aufweist als die der Basiskarte und eine Verteilungsschrittweite von Kontakten zur Aufnahme der Mikrokomponenten aufweist, die kleiner ist als diejenige der Basiskarte und wobei die Hauptkarte und die Basiskarte auf einer gemeinsamen Transportträgerplatte zugeführt werden;
b) die Mikrokomponenten auf die zwei Karten auf einer automatischen Maschine befestigt werden, und zwar nach dem Übertrag und der Zentrierung der Hauptkarte auf der Basiskarte;
c) die so gebildete Gesamtheit auf eine Temperatur zum Schmelzen der Verschweißung oder der Verlötung der Kugeln und der Komponenten gebracht wird.

10. Verfahren nach Anspruch 9, **dadurch gekennzeichnet, daß** an dem Rand der unteren Seite der Hauptkarte in gleicher Weise Zusatzkugeln angeordnet werden, und zwar mit größerem Durchmesser als die ersteren, wobei die Zusatzkugeln dazu bestimmt sind, in Löcher (26) der Basiskarte einzugreifen, um die Hauptkarte während des Verfahrens mechanisch zu zentrieren und die Hauptkarte auf der fertiggestellten Anordnung zu befestigen.

## Claims

1. Unitary assembly of electronic cards carrying microcomponents, comprising:
a base printed circuit card (10) carrying electronic microcomponents having outputs distributed at a first pitch,
at least one core card (12) having a size smaller than that of the base card, carrying microcomponents,
said core card (12) being mechanically and electrically connected to the base card by electrically conductive solder beads (18) distributed according to a two-dimensional array,
some at least of the microcomponents carried by the core card having outputs distributed at a second pitch, smaller than the first pitch,
characterized in that the base card is made using a technology enabling at most a contact density lesser than that of the core card and in that the conductive beads are directly located between the core card and the base card.

2. Assembly according to claim 1, characterized in that the electrically conductive beads (18) are located only in a central portion of the core card.

3. Assembly according to claim 1 or 2, characterized in that it further comprises at least one component secured to the core card and having a greater size than the microcomponents secured to the base card.

4. Assembly according to claim 2, characterized in that it comprises microcomponents (20) located under the core card (12) and secured to the base card (10) around the conducting beads.

5. Assembly according to any one of the preceding claims, characterized by solder pellets (24) engaging into holes (26) formed through the base card and located around the conducting beads.

6. Assembly according to claim 5, characterized in that three or four solder pellets are distributed in a peripheral portion of the core card.

7. Assembly according to claim 5 or 6, characterized in that the pellets are formed from beads having a diameter higher than that of the electrically conducting solder beads (18).

8. Assembly according to any one of claims 1-7, characterized in that the base card (10) is made of fiber glass reinforced resin and the core card is made of embedded crossed fiber glass cloth.

9. A method for manufacturing a unitary assembly of electronic cards according to claim 1, comprising the steps of:
(a) during a same manufacturing phase, silk printing brazing cream on contact pads of a base printed circuit card (10), with a first distribution spacing of contacts for receiving microcomponents and silk printing brazing cream on contact pads formed on a surface of a core card (12) with the same spacing of the contact pads as on the base card, for constituting brazing beads, the core card having a size smaller than that of the base card, having a distribution pitch between contacts for receiving microcomponents shorter than the pitch on the base card, the core card and the base card being carried by a same transport support plate;
(b) securing the microcomponents on the two cards on an automatic machine, and, after the core card is located and centered on the base printed circuit card,
(c) heating the so-obtained assembly to a temperature which is sufficient for reflow soldering or brazing of the beads and components.

10. Method according to claim 9, characterized by additionally forming additional beads in a peripheral portion of the lower face of the core printed circuit card, said additional beads having a greater diameter than the first ones,intended to be engaged into holes (26) of the base card for mechanically centering the core printed circuit card during the process and for securing the core card in the complete assembly.
